# FASCICULE DE BREVET EUROPEEN

(11) **EP 2 471 093 B1**
(45) Date de publication et mention de la délivrance du brevet: **05.06.2013**
(21) Numéro de dépôt: 10763750.6
(22) Date de dépôt: 25.08.2010
(51) Int. Cl.: H01L 21/762

(54) **PROCÉDÉ DE DÉTACHEMENT PAR FRACTURE D'UN FILM MINCE DE SILICIUM METTANT EN OEUVRE UNE TRIPLE IMPLANTATION**
VERFAHREN ZUR ABLÖSUNG EINES DÜNNSCHICHT-SILIZIUMFILMS MITTELS TRENNUNG ANHAND DREIFACHER IMPLANTATION
METHOD FOR DETACHING A SILICON THIN FILM BY MEANS OF SPLITTING, USING TRIPLE IMPLANTATION

(30) Priorité: 26.08.2009 FR 0955826
(43) Date de publication de la demande: 04.07.2012
(73) Titulaire: Commissariat à l'Énergie Atomique et aux Énergies Alternatives, 75015 Paris (FR)
(72) Inventeur: TAUZIN, Aurélie, F-38120 Saint Egrève (FR)
(74) Mandataire: Colombo, Michel
(86) Numéro de dépôt international: PCT/FR2010/051774
(87) Numéro de publication internationale: WO 2011/023905

(56) Documents cités:
- EP-A2- 1 798 765
- US-A- 5 877 070
- US-A1- 2004 224 482
- US-A1- 2005 026 426
- BRUNO ET AL: "He implantation in Si for B diffusion control" NUCLEAR INSTRUMENTS & METHODS IN PHYSICS RESEARCH, SECTION - B:BEAM INTERACTIONS WITH MATERIALS AND ATOMS, ELSEVIER, AMSTERDAM, NL LNKD- DOI:10.1016/J.NIMB.2007.01.034, vol. 257, no. 1-2, 1 avril 2007 (2007-04-01), pages 181-185, XP022014683 ISSN: 0168-583X

## Description

L'invention concerne un procédé de détachement d'un film mince à partir d'un substrat, mettant en oeuvre une implantation de plusieurs espèces et ayant une sensibilité contrôlée à des traitements thermiques à haute température.

La technique de détachement d'un film mince à partir d'un substrat à partir d'une implantation d'une espèce adaptée à former une couche fragilisée est notamment décrite dans le document US - 5 374 564 (Bruel) et des documents qui en concernent des perfectionnements, tel que le document US - 6 020 252 (Aspar). Ce procédé est couramment mis en oeuvre sous la dénomination « Smart Cut^{™}».

### Etat de la technique

Le procédé « Smart Cut^{™} » permet le détachement d'un film mince et son transfert sur un raidisseur par les étapes suivantes :
- 1. bombardement d'une face d'un substrat initial (typiquement en silicium) avec des espèces gazeuses (H ou gaz rares, tel que de l'hélium), afin d'implanter ces ions en concentration suffisante pour créer (après un éventuel traitement thermique) une couche de microcavités, donc une couche fragilisée
- 2. mise en contact intime de cette face du substrat avec un raidisseur (en pratique un autre substrat, par exemple en silicium aussi), notamment par collage moléculaire (le traitement thermique mentionné à l'étape 1 peut être constitué par un traitement thermique effectué après cette mise en contact intime pour consolider le collage moléculaire), et
- 3. fracture au niveau de la couche de microcavités, par l'application d'un traitement thermique de recuit et/ou d'une contrainte de détachement (par exemple, l'insertion d'une lame entre les deux substrats et/ou encore des efforts de traction et/ou de flexion et/ou de cisaillement, et/ou encore l'application d'ultrasons ou de micro-ondes de puissance et de fréquence judicieusement choisies) ; on obtient ainsi un film mince (la couche du substrat initial sous laquelle les microcavités ont été créées), et un reliquat de substrat (compte tenu de la finesse du film mince, l'épaisseur de ce reliquat a en pratique peu diminué).
- 4. recyclage du substrat (à savoir du reliquat de l'étape 3) pour un nouveau cycle d'implantation, de mise en contact et de fracture ; et ainsi de suite.

L'étape 1 consiste généralement en une implantation d'hydrogène ou d'hélium, typiquement à une énergie de 10 à 210 keV et à une dose de quelques 10¹⁶/cm² à quelques 10¹⁷/cm². L'étape 3 de fracture peut alors correspondre, pour l'essentiel (il peut y avoir un apport modéré d'une autre forme d'énergie), à un traitement thermique de recuit dans la gamme des 200 à 700°C, selon les conditions d'implantation choisies (énergie, dose, température, flux d'ions, etc...). La durée de ce traitement thermique jusqu'à la fracture dépend de la température de ce traitement de recuit (et des conditions d'implantation, de l'éventuel recuit antérieur de consolidation du collage ou de tout autre traitement thermique antérieur) : de manière générale, toutes choses étant égales par ailleurs, plus la température de recuit est élevée, plus le temps de ce recuit nécessaire à la fracture est court (voir notamment : Kinetics of Splitting in the Smart Cut™ Process, Aspar et al., Proceedings 1998 IEEE International SOI Conférence, Oct. 1998 ; pp. 137-138).

Certaines applications, comme le transfert d'hétérostructures (Ge sur Si ou GaN sur Saphir), nécessitent que le recuit de fracture soit effectué à très basse température pour limiter les contraintes mécaniques liées à la différence de dilatation thermique des matériaux assemblés. Dans d'autres applications, il peut y avoir, avant fracture, la formation au moins partielle de composants sur le futur film mince, alors que ces composants ne peuvent pas supporter des températures élevées. Pour ce faire, différentes adaptations permettent d'abaisser la température du traitement de fracture sans pour autant exiger, pour ce traitement de fracture, des durées de traitement rédhibitoires dans un contexte industriel. Ainsi, il est connu par les documents
- APL 72 p.49, 1998,
- US - 5 877 070 (Goesele et al),
qu'une co-implantation Bore - Hydrogène permet de diminuer la température de recuit de fracture jusqu'à 200°C ; la fracture peut alors être obtenue en 24h par exemple.

De même il est connu qu'une co-implantation Hélium - Hydrogène permet de diminuer la température de fracture tout en nécessitant une durée industriellement acceptable (voir notamment : C. Lagahe-Blanchard et al., Proceedings on the Semiconductor Wafer Bonding VII: Science, Technology, and Applications, Paris, France, 27 April-2 May 2003, Electrochemical Society, Pennington, NJ, 2003, Vol. PV2003-19, p. 346, ou P. Nguyen et al., Proceedings of the 2003 IEEE International SOI Conference, Newport Beach, CA, 29 September-2 October 2003 IEEE, Piscataway, NJ, 2003, p. 132).

On peut également se référer aux documents US - 6 600 173 (Tiwari), WO - 2004/042779 (SOITEC-CEA), WO - 2004/044976 (CEA), WO - 2005/013318 (SOITEC), ou WO - 2004/043615 (SOITEC-CEA) ou encore l'article intitulé « Efficient production of silicon-on-insulator fims by co-implantation of He⁺ with H⁺" par Agarwal et al (Applied Phys Letters, Vol 72, N°9, mars 1998.

On peut noter que, dans ce contexte, le fait d'implanter du bore ou de l'hélium en combinaison avec de l'hydrogène a principalement visé à faciliter la fracture (ou à en améliorer la qualité de surface), en réduisant avantageusement la dose totale d'implantation et/ou le budget thermique de fracture.

Au contraire, pour certaines applications il est nécessaire de procéder à des étapes impliquant un traitement thermique à haute température après l'implantation mais avant la fracture, voire avant le collage ; la contribution à la fracture du traitement thermique de fracture ne peut alors être significative que si la température de ce traitement thermique de fracture est suffisamment élevée par rapport à celles des étapes antérieures. On peut rappeler à cet égard que le collage moléculaire de l'étape 2 sera d'autant meilleur (forces de collage plus élevées) qu'il aura été consolidé à haute température..A titre d'exemple, plus le recuit de fracture compatible avec l'application considérée est important (température élevée, temps long), plus la consolidation du collage avant fracture peut être importante, et donc plus le film transféré sera de bonne qualité (en ce qui concerne en particulier sa liaison avec son raidisseur). Pour d'autres applications, un dépôt d'oxyde à haute température (oxyde dit « HTO »), par exemple d'épaisseur 2 à 3 µm réalisé à 700°C, sur des plaques implantées (donc notamment sur le substrat dont on veut détacher un film mince) peut être nécessaire pour pouvoir coller les plaques. Toutefois, l'application de hautes températures peut conduire à des temps de fracture très courts qui ne sont pas applicables industriellement ; en outre, il est nécessaire de garantir que la fracture n'intervient pas lors d'un traitement thermique antérieur à l'étape prévue pour l'obtention de cette fracture.

Il faut préciser ici que, de manière générale, on cherche actuellement à détacher des films minces qui peuvent avoir des épaisseurs très variables, notamment des films minces de très faible épaisseur, de moins de 2µm, voire de moins de 300 nm, tout en garantissant que l'état de surface des faces mises à nu par le détachement soit suffisamment bon pour ne pas nécessiter des traitements de finition longs et coûteux.

### Problème technique et solution de l'invention

On comprend qu'il existe ainsi le besoin de pouvoir réaliser, après une implantation, des étapes technologiques impliquant un budget thermique important (notamment à des températures supérieures à 450°C-500°C) sans détériorer la surface (par formation de cloques ou par exfoliation) tout en permettant une fracture thermique (à une température éventuellement élevée appliquée pendant un temps compatible industriellement) ou mécanique ultérieure bien contrôlée, y compris lorsqu'il faut détacher des films particulièrement minces.

C'est pourquoi un objet de l'invention est de proposer un procédé de détachement par implantation qui soit compatible avec des traitements thermiques à haute température, typiquement à plus de 500°C, mis en oeuvre, lors d'étapes technologiques (typiquement de formation de couches par épitaxie ou de composants, etc...) ou pendant l'étape de fracture, y compris dans le cas de films minces de très faible épaisseur (inférieure à 300 nm).

De manière générale, l'invention vise à ralentir la fracture de sorte que le détachement thermique puisse être réalisé à haute température pendant un temps suffisamment long (et donc compatible industriellement). Cela revient donc à l'inverse de la démarche ayant consisté à prévoir une implantation d'hydrogène et de bore ou d'hélium pour permettre une fracture de détachement à basse température.

L'invention propose à cet effet un procédé de détachement par fracture d'un film mince de silicium à partir d'un substrat de départ, comportant
- une étape d'implantation d'espèces au sein du substrat de départ, au travers d'une face libre, en vue de la formation d'une couche de fragilisation, le substrat de départ étant, au moins dans sa partie située sous la face libre, sur une profondeur au moins égale à l'épaisseur du film mince à détacher, constitué de silicium,
- au moins une étape intermédiaire impliquant un traitement thermique à une température d'au moins 450°C,
- une étape de détachement par fracture le long de la couche de fragilisation,
   caractérisé en ce que l'étape d'implantation comporte une implantation de bore, une implantation d'hélium et une implantation d'hydrogène, dans un ordre quelconque, avec des énergies d'implantation telles que :
   - on obtient des maxima de concentration en hélium et en bore qui sont sensiblement à une même profondeur, avec un écart d'au plus 10 nm,
   - on obtient un maximum de concentration en hydrogène à une profondeur supérieure d'au moins 20 nm à celle des maxima de concentration en hélium et en bore,
      et avec des doses d'implantation telles que :
      - la dose de bore est au moins égale à 5.10¹³ B/cm²
      - la dose totale d'hélium et d'hydrogène est au moins égale à 10¹⁶ atomes/cm² et au plus égale à 4.10¹⁶ atomes/cm², voire 3.10¹⁶ atomes/cm².

L'invention s'applique à tout type de silicium : monocristallin, polycristallin ou amorphe, dopé ou non...

On comprend que, notamment pour le détachement de films minces de grande épaisseur (typiquement au dessus de 2 microns), il peut ne pas être nécessaire de prévoir une étape de solidarisation (par mise en contact intime) à un raidisseur.

On pourra noter que, pour l'essentiel, ce procédé reprend des étapes classiques du procédé actuellement connu sous la désignation « Smart Cut^{™} » sauf pour l'étape 1.

En effet l'étape 1 comprend, selon l'invention, des implantations des trois espèces ioniques suivantes : Bore, Hélium, Hydrogène, avec quelques conditions assez précises entre ces implantations.

Ainsi qu'on le sait, le bore est une espèce de nature différente de celle de l'hydrogène ou de l'hélium qui sont des gaz et dont les atomes sont plus petits.

Comme indiqué ci-dessus, il était déjà connu d'implanter de l'hélium en combinaison avec de l'hydrogène ; il était de même déjà connu d'implanter du bore en combinaison avec de l'hydrogène. Mais ces co-implantations étaient essentiellement proposées en vue de réduire les températures de détachement ou les doses totales d'implantation, par rapport à une implantation d'hydrogène seul (ou d'hélium seul).

Pourtant, de manière surprenante, il a été constaté que, par rapport à une mise en oeuvre d'une implantation unique d'hydrogène, telle que définie par exemple dans le document US - 5 374 564 (Bruel) précité, à des doses de quelques 10¹⁶/cm² avec des énergies comprises entre 10 et 1000 keV et avec une fracture thermique obtenue au-dessus de 500 °C, le fait d'implanter en complément de l'hélium et du bore dans les conditions de l'invention a pour avantage que la fracture thermique nécessite un budget thermique plus important, ce qui permet d'inclure des étapes technologiques à haute température sans risquer une fracture prématurée.

A fortiori, il a été constaté, de manière tout aussi surprenante que, par rapport à une mise en oeuvre impliquant une implantation d'hydrogène en combinaison avec du bore, telle que décrite par exemple dans le document US - 5 877 070 (Goesele) précité avec une dose d'hydrogène de 10¹⁷ H/cm² avec une énergie de 60 ou de 129 keV et une dose de bore représentant entre 0.1 % et 1 % de la dose d'hydrogène (5.10¹⁴ B/cm² avec une énergie de 180 keV) et un traitement thermique de sensibilisation à 250°C puis une fracture à une température au plus égale à la température de sensibilisation, le fait d'implanter en outre de l'hélium, dans les conditions de l'invention a pour avantage de retarder la fracture thermique (voire la bloquer, auquel cas un supplément d'énergie doit être fourni sous forme mécanique).

De même, par rapport à une mise en oeuvre impliquant une implantation d'hydrogène en combinaison avec de l'hélium, telle que décrite par exemple dans le document WO - 2004/042779 précité avec, à titre d'exemple, une dose d'hydrogène de 4,5 x 10¹⁶ H/cm² à une énergie de 30 keV et une dose d'hélium de 2.10¹⁶ He/cm² à une énergie de 45 keV et un détachement de fracture à 275°C, le fait d'implanter en outre du bore dans les conditions de l'invention a pour avantage de retarder la fracture thermique (voire la bloquer, auquel cas un supplément d'énergie doit être fourni sous forme mécanique).

En fait, le principe d'une triple implantation impliquant de l'hydrogène, de l'hélium et du bore est déjà évoqué dans le document EP - 1 798 765 (Coming), mais il ne s'agit que de propositions vagues et incertaines puisque les exemples décrits ne portent que sur des cas de double implantation ; en fait le principe d'implantations multiples proposé par ce document est guidé par un souci de réduction des coûts, ce qui va a priori à l'encontre du souci de ralentissement qui est à la base du problème technique visé par l'invention ; a fortiori, ce document ne divulgue ni ne suggère les conditions d'implantation préconisées par l'invention ni leurs avantages.

De manière avantageuse, surtout pour le détachement de films minces d'épaisseurs particulièrement faibles (d'au plus quelques centaines de nanomètres), une étape de solidarisation à un raidisseur (par mise en contact intime avec celui-ci) est prévue entre l'implantation et l'étape de détachement par fracture (l'étape intermédiaire à haute température, voire l'étape de détachement, peut alors être constituée par un traitement permettant de consolider l'interface de collage) ; plus généralement, l'étape intermédiaire (elle peut ne pas être unique) est avantageusement une étape technologique à fort budget thermique, typiquement à une température au moins égale à 450°C, voire 500°C, telle qu'un traitement de consolidation mais aussi un traitement de dépôt d'une couche, notamment par épitaxie, etc...

Selon des caractéristiques avantageuses de l'invention, éventuellement combinées :
- la dose d'implantation de bore est au moins égale à 1 % de la dose totale d'hélium et d'hydrogène et au plus égale à 10% de cette dose totale, ce qui implique que la dose de bore représente une proportion significative mais faible de la dose totale d'hélium et d'hydrogène,
- chacune des doses d'hélium et d'hydrogène est de préférence au moins égale à 10¹⁵ atome/cm², ce qui revient à dire que chacune de ces espèces est présente à un niveau significatif et qu'il y a une vraie synergie entre ces espèces,
- les doses d'hélium et d'hydrogène sont avantageusement dans un rapport compris entre ½ et 2, ce qui signifie qu'elles sont avantageusement dans un même ordre de grandeur,
- la distance entre les maxima de concentration en hélium et en bore, d'une part, et le maximum de concentration en hydrogène, d'autre part, est au plus égale à 200 nm,
- la fracture est obtenue par un traitement thermique de fracture qui est au moins en partie réalisé à une température au moins égale à 450°C, voire 600°C,
- la fracture est provoquée par application d'une énergie sous forme mécanique (impulsion ou choc, insertion d'une lame, couple, ultrasons, etc...).

### Brève description des dessins

Des objets, caractéristiques et avantages de l'invention ressortent de la description qui suit, donnée à titre indicatif non limitatif, donnée en regard du dessin annexé sur lequel :
- la figure 1 est une vue schématique en coupe d'un substrat faisant l'objet d'une étape d'implantation du procédé de l'invention,
- la figure 2 en est une vue similaire, après une étape de mise en contact intime avec un second substrat,
- la figure 3 en est une vue similaire après une étape de fracture, et
- la figure 4 en est une vue similaire, montrant le substrat initial prêt pour un nouveau cycle de mise en oeuvre du procédé de l'invention.

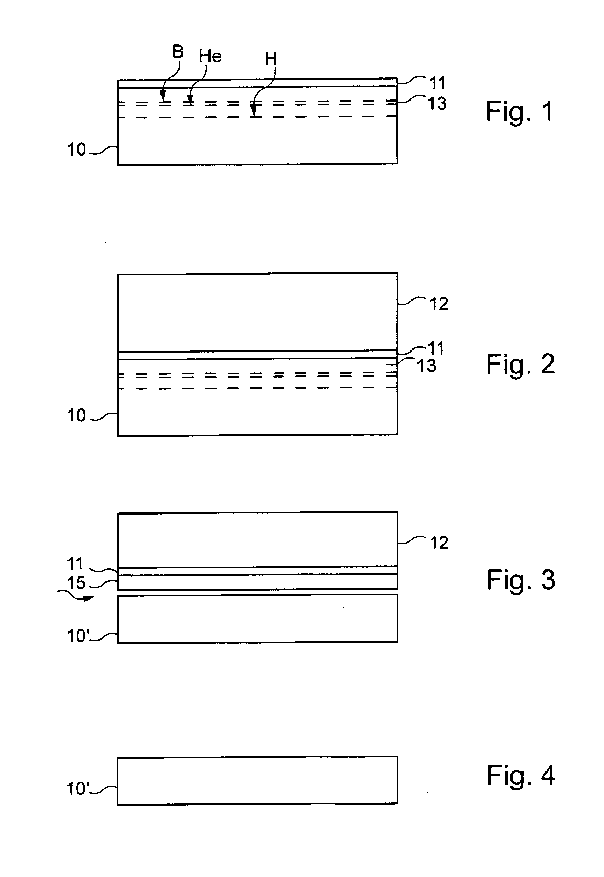

La figure 1 représente un substrat initial 10, ici constitué de silicium monocristallin ; en variante, ce substrat peut notamment être constitué d'une couche de silicium monocristallin porté par un substrat porteur, par exemple en silicium polycristallin. De manière classique, ce substrat 10 est ici recouvert d'une couche 11 d'oxyde thermique, obtenu lors d'étapes antérieures (une telle couche d'oxyde peut être omise).

Ce substrat initial a fait l'objet d'une triple implantation, à savoir d'une implantation de bore, d'une implantation d'hydrogène et d'une implantation d'hélium.

L'ordre d'implantation de ces trois espèces n'est pas apparu avoir d'effet sur la suite du procédé de détachement par fracture.

Les énergies d'implantation sont choisies de sorte que les pics d'hélium et de bore sont :
- moins profonds que le pic d'hydrogène, d'une distance au moins égale à 20 nm, avantageusement au plus égale à 200 nm.
- localisés tous deux à la même profondeur, ou situés à une faible distance l'un par rapport à l'autre (jusqu'à 10nm en pratique).

Une technique appropriée pour de telles mesures de profondeur semble être la spectrométrie de masse par ions secondaires (SIMS ou « Secondary Ions Mass Spectrometry »), qui donne des résultats différents de ceux que l'on peut obtenir par simulation, par exemple à l'aide du logiciel CTRIM (« Cristal Transport of Ions in Matter »).

Les doses d'implantation sont choisies telles que :
- la dose de bore est au moins égale à 5.10¹³ B/cm², de préférence au moins égale à 10¹⁴ B/cm² ; elle est de préférence inférieure à 10¹⁶ B/cm² pour éviter une amorphisation du substrat ; il est encore plus avantageux que cette dose de bore ne représente pas plus de 10% de la dose combinée d'hydrogène et d'hélium,
- la dose totale d'hydrogène et d'hélium (dose H + dose He) est au moins égale à 10¹⁶ /cm², de préférence au plus égale à 4.10¹⁶ /cm², avantageusement au plus égale à 3.10¹⁶ /cm².

Ainsi la dose de bore est avantageusement comprise entre 1 et 100 fois plus faible que la dose cumulée de H+He.

Le futur film mince est situé entre la surface au travers de laquelle les implantations sont effectuées, et les pics d'hélium et de bore (où est très largement concentré le dommage provoqué par les implantations (ce dommage pourra évoluer entre cette triple implantation et la fracture)).

De même que pour le procédé « Smart Cut^{™} » connu, le substrat 10 est ensuite (voir la figure 2) avantageusement mis en contact intime avec un raidisseur 12, ici un substrat de même nature que le substrat initial 10, à savoir du silicium monocristallin (il peut être aussi recouvert, le long de sa surface en regard du substrat 10, d'une couche d'oxyde, non représentée). Cette mise en contact est avantageusement réalisée par un collage moléculaire ; un traitement thermique peut alors être utile pour consolider ce collage, avant le détachement du film mince.

A la figure 2, la référence 13 représente une couche fragilisée résultant de la triple implantation précitée, et d'éventuels traitements thermiques subis lors de ces implantations ou à leur suite, par exemple pour la consolidation du collage du raidisseur.

Ensuite (voir la figure 3), la fracture est provoquée au niveau de la couche fragilisée 13, sensiblement au niveau d'implantation du bore et de l'hélium, par l'application d'énergie thermique éventuellement complétée par une autre forme d'énergie (schématisée par une flèche), par exemple par l'application d'une contrainte de détachement (par exemple, l'insertion d'une lame entre les deux substrats et/ou encore des efforts de traction et/ou de flexion et/ou de cisaillement, et/ou encore l'application d'ultrasons ou de micro-ondes de puissance et de fréquence judicieusement choisies). On obtient ainsi un film mince 15 constitué par la partie du substrat initial qui reste solidarisée au second substrat 12, ainsi qu'un reliquat du substrat initial, ici noté 10'.

Ce reliquat peut alors être utilisé pour un autre cycle d'implantation-solidarisation-fracture (figure 4) après un éventuel recyclage, par exemple à l'aide d'un polissage et/ou d'un traitement thermique adapté.

### Résultats expérimentaux

Les conditions opératoires préconisées pour la triple implantation sont fondées sur les résultats suivants.

### Effet de l'ordre d'implantation

Des conditions opératoires d'implantation ont été fixées, à titre de référence, comme suit :
- Bore (80keV et 10¹⁵/cm²), Hélium (34keV et 1,2.10¹⁶/cm²), Hydrogène (27keV et 1,2.10¹⁶/cm²).

Des recuits ont ensuite été effectués à 500°C-10min, ou 700°C-10min pour évaluer l'effet de ces conditions opératoires.

Les implantations ont été effectuées selon les ordres suivants :
- B puis He puis H,
- B puis H puis He,
- H puis B puis He,
- H puis He puis B,
- He puis H puis B, et
- He puis B puis H.

Ces diverses combinaisons quant à l'ordre des implantations, toutes choses étant identiques par ailleurs, aussi bien pour le traitement thermique à 500°C-10 mn que pour celui à 700°C-10mn, ont conduit à des résultats identiques, à savoir l'absence de cloquage à la fin du recuit, ce qui signifie qu'il n'y a pas eu de fracture intempestive avant la fin du traitement thermique, que ces conditions d'implantation ne conduisent pas à une fracture thermique en 10 mn à 500°C ni même à 700°C, et que pour obtenir une fracture il est même utile d'appliquer une autre forme d'énergie, notamment de l'énergie mécanique.

Il mérite toutefois d'être mentionné que, en l'absence d'une telle implantation triple, la fracture interviendrait plus rapidement ; c'est ainsi que, à titre d'exemple, en cas d'implantation d'hydrogène seul avec une dose similaire au total de l'hélium et de l'hydrogène précité, ou en cas d'implantation d'hydrogène et d'hélium sans bore, on obtient une fracture purement thermique (sans apport complémentaire d'énergie mécanique) en environ 10 minutes à 500°C ; en cas d'implantation d'hydrogène et de bore, sans hélium, on obtient une fracture purement thermique en 11 secondes environ à 500°C. Avec la triple implantation préconisée par l'invention, la fracture thermique ne s'observe qu'après 2 heures à 500°C.

Sous toutes réserves, il semblerait que, alors qu'une implantation d'hydrogène seul conduit à des défauts approximables à des cavités étirées de type microfissures, de longueur dans le plan de fragilisation de l'ordre de 50 à 100 nm, la triple implantation de l'invention conduit quant à elle, plutôt à des défauts globalement sphériques de 10 nm à 20 nm de diamètre environ.

### Effet de l'énergie d'implantation de l'hélium et de celle de l'hydrogène

Pour évaluer l'incidence de l'énergie d'implantation de l'hélium, des conditions opératoires ont été fixées, à titre de référence, comme suit, par analogie à celles mentionnées ci-dessus :
- Bore (80keV et 10¹⁵/cm²), Hélium (énergie variable et 1,2.10¹⁶/cm²), Hydrogène (27keV et 1,2.10¹⁶/cm²),

Les effets de l'implantation sont, comme précédemment, évalués au moyen de recuits à 500°C-10min, ou 700°C-10min.

En faisant varier l'énergie d'implantation de He, de manière décroissante depuis 55 keV jusqu'à 24 keV, on constate que :
- lorsque l'énergie diminue de 55 keV vers 34 keV, le cloquage constaté pour l'énergie la plus haute tend à diminuer,
- lorsque l'énergie est à 34 keV, il n'y a pas de cloquage,
- lorsque l'énergie diminue ensuite, de 34 à 24 keV, le cloquage augmente.

Il en découle qu'une implantation d'hélium à 34 keV correspond à un ralentissement maximum du phénomène thermique contribuant à la fracture de détachement, et que ce ralentissement est de moins en moins sensible au fur et à mesure qu'on s'éloigne de cette valeur optimale, au-dessus ou en dessous de celle-ci. En d'autres termes, il y a une profondeur d'implantation qui apparaît être optimale (de l'ordre de 200 nm, d'après le tableau ci-dessous, dans le cas du silicium recouvert d'une couche d'oxyde thermique de 100 nm, soit 100 nm sous cette couche), ce qui correspond à la profondeur d'implantation du Bore.

Pour évaluer l'incidence de l'énergie d'implantation de l'hydrogène, des conditions opératoires ont été fixées, à titre de référence, comme suit (par analogie à celles définies ci-dessus) :
- Bore (80keV et 10¹⁵/cm²), Hélium (34keV et 1,2.10¹⁶/cm²), Hydrogène (énergie variable et 1,2.10¹⁶/cm²)
- recuits à 500°C-10min, ou 700°C-10min.

En faisant varier l'énergie d'implantation de H, de manière décroissante depuis 50 keV jusqu'à 20 keV (soit sensiblement la même plage de variation que pour l'hélium), on constate que :
- lorsque l'énergie diminue de 50 vers 27 keV, il n'y a pas de cloquage,
- lorsque l'énergie diminue ensuite, de 27 à 20 keV, le cloquage augmente.

Il en découle qu'une implantation d'hydrogène à une énergie de 50 keV à 27 keV correspond à un ralentissement maximum du phénomène thermique contribuant à la fracture de détachement, et que ce ralentissement est de moins en moins sensible au fur et à mesure qu'on diminue l'énergie en dessous de 27 keV. En d'autres termes, il y a une profondeur d'implantation qui apparaît être minimale (de l'ordre de 230 nm, d'après le tableau ci-dessous, dans le cas du silicium recouvert d'une couche d'oxyde thermique de 100 nm, soit 130 nm sous cette couche).

Les résultats obtenus en implantant, soit de l'hélium avec des énergies variant au-dessus ou en dessous de 34 keV, soit de l'hydrogène avec des énergies au-dessus ou en dessous de 27 keV, soit du bore à la valeur optimale précitée, sont recensés dans le tableau suivant, correspondant à des substrats de départ en silicium monocristallin recouvert d'une couche d'oxyde thermique de 10 nm. La grandeur Cmax correspond à la profondeur à laquelle la densité d'implantation est maximale (simulée à l'aide du logiciel CTRIM, c'est-à-dire « Cristal TRansport of Ions in Matter », ainsi que mesurée par la méthode SIMS (« Secondary Ions Mass Spectrometry) » :

| Ion - Energie | Profondeur Cmax (SIMS) | Profondeur Cmax (CTRIM) |
|---|---|---|
| Bore 80 keV | 195 nm | 190 nm |
| Hydrogène 20 keV | 190 nm | 200 nm |
| Hydrogène 27 keV | 230 nm | 253 nm |
| Hydrogène 40 keV | 346 nm | 370 nm |
| Hydrogène 50 keV | 400 nm | 447 nm |
| Hélium 25 keV | 134 nm | 185 nm |
| Hélium 34 keV | 200 nm | 265 nm |
| Hélium 45 keV | 280 nm | 340 nm |
| Hélium 55 keV | 334 nm | 400 nm |

C'est sur la base des mesures SIMS qu'ont été définies les conditions sur les positions relatives des différents pics. Il semble que ce soit la position du pic de bore qui détermine l'épaisseur du futur film mince.

### Effet des doses d'implantation de bore, d'hélium et d'hydrogène

Pour évaluer l'incidence de la dose d'implantation du bore, des conditions opératoires ont été fixées comme suit (par analogie à celles définies ci-dessus) :
- Bore (80keV avec une dose variable), Hélium (34keV et 1,2.10¹⁶/cm²), Hydrogène (27 keV et 1,2.10¹⁶/cm²),
- recuits à 500°C-10min, ou 700°C-10min.

Avec une concentration de bore comprise entre 6.10¹⁴ at/cm³ et 10.10¹⁴ at/cm³, ce qui correspond à une dose surfacique d'à peine de l'ordre de 10¹⁰ at/cm², c'est-à-dire une dose très faible, on observe une fracture classique, telle qu'on l'observe, notamment, avec une simple implantation d'hydrogène, avec des défauts de type microfissures.

Si l'on augmente la dose (donc la concentration) de bore d'un ordre de grandeur (par multiplication d'environ d'un facteur 10), on constate que la fracture est accélérée.

Une nouvelle augmentation, par implantation, de la dose (concentration) de bore d'un ordre de grandeur, à de l'ordre de 10¹³at/cm² (de l'ordre de 6.10¹⁷ at/cm³) conduit à un ralentissement de la fracture, qui se traduit par une multiplication par 3 du temps de fracture, ou par la possibilité d'augmenter la température de recuit de fracture d'environ 25° tout en conservant la même durée avant fracture. On comprend que l'effet de l'invention commence à apparaître à partir de cet ordre de grandeur ; toutefois, il est apparu qu'il peut subsister des risques de fracture intempestifs en cas d'application de certaines étapes technologiques à haute température, de sorte qu'il semble préférable de se situer au dessus de ce seuil.

Une nouvelle augmentation de la dose de bore d'un ordre de grandeur, à de l'ordre de 10¹⁴ at/cm² (6.10¹⁸ at/cm³) se révèle avoir pour effet de bloquer la fracture thermique ; en effet, la fracture après un recuit à des températures de 600°C à 900°C pendant 1 h n'a pas suffit en soi pour conduire à la fracture, et il a fallu ajouter une autre forme d'énergie (par insertion d'une lame).

Ce blocage de la fracture thermique s'observe aussi, sans qu'il y ait même de cloquage, avec une dose encore plus importante, d'un ordre de grandeur, soit à 10¹⁵/cm² (6.10¹⁹ at/cm³).

Il apparaît ainsi qu'en dessous d'une dose de bore de 10¹³ at/cm² la présence de bore nuit à l'objectif de l'invention, mais qu'au-delà, la présence de bore, en combinaison avec de l'hydrogène et de l'hélium, contribue à ralentir l'évolution, à traitement(s) thermique(s) égal (égaux), de la couche de microcavités et donc de la fracture. L'effet de ralentissement est tout particulièrement sensible à partir de 10¹⁴ at/cm² et semble devoir se produire aussi pour des doses supérieures, notamment à de l'ordre de 10¹⁵ at/cm² (mais il est recommandé de ne pas augmenter beaucoup la dose de bore au-delà de cette gamme, compte tenu des autres effets que peut avoir le bore, notamment en termes d'amorphisation).

Pour évaluer l'incidence de la dose d'implantation d'hydrogène, des conditions opératoires ont été fixées, à titre de référence, comme suit (par analogie à celles définies ci-dessus) :
- Bore (80keV et 10¹⁵ at/cm²), Hélium (34keV et 1.10¹⁶ at/cm²), Hydrogène (27 keV à une dose variable),
- recuit à 500°C-10min, ou 700°C-10min.

On a observé que, au fur et à mesure que l'on fait baisser la dose de 4.10¹⁶ at/cm² à 1.10¹⁶ at/cm², le cloquage diminue, jusqu'à ne plus être perceptible à 10¹⁶ at/cm².

Il en découle que, toutes conditions étant similaires par ailleurs, une dose d'hydrogène de l'ordre de 10¹⁶ at/cm² (ce qui englobe, bien sûr, la valeur de 1,2.10¹⁶ at/cm² mentionnée dans les conditions de référence identifiées plus haut) paraît définir un optimum (en dessous, la dose n'est plus suffisante pour obtenir une couche de microcavités suffisamment régulière pour obtenir, finalement, un état de surface satisfaisant après le détachement par fracture).

Pour évaluer l'incidence de la dose d'implantation d'hélium, des conditions opératoires ont été fixées, à titre de référence, comme suit (par analogie à celles définies ci-dessus) :
- Bore (80keV et 10¹⁵ at/cm²), Hélium (34keV avec une énergie variable), Hydrogène (27 keV et 1.10¹⁶ at/cm²),
- recuit à 500°C-10min, ou 700°C-10min.

On a observé que, au fur et à mesure que l'on fait baisser la dose d'hélium de 4.10¹⁶ at/cm² à 1.10¹⁶ at/cm², le cloquage commence par augmenter (entre 4.10¹⁶ at/cm² et 3.10¹⁶ at/cm²) puis diminue jusqu'à ne plus être vraiment perceptible à 1.10¹⁶ at/cm².

Il en découle que, toutes conditions étant similaires par ailleurs, une dose d'hélium de l'ordre de 10¹⁶ at/cm² (ce qui englobe, bien sûr, la valeur de 1,2.10¹⁶ at/cm² mentionnée dans les conditions de référence identifiées plus haut) paraît définir un optimum (en dessous, la dose n'est plus suffisante pour obtenir une couche de microcavités suffisamment régulière pour obtenir, finalement, un état de surface satisfaisant après le détachement par fracture).

Plus généralement, on comprend qu'une gamme opératoire particulièrement intéressante pour la triple implantation, dans un ordre quelconque, est définie comme suit :
les énergies d'implantation sont telles que :
   - on obtient des maxima de concentration d'hélium et de bore sensiblement à une même profondeur, avec un écart d'au plus 10 nm,
   - ces maxima sont moins profonds que le maximum de concentration d'hydrogène,
et les doses d'implantation sont telles que :
   - la dose de bore est au moins égale à 10¹³ B/cm² (typiquement au moins égale à 5.10¹³ B/cm²),
   - la dose totale d'hélium et d'hydrogène est comprise entre 10¹⁶ atomes/cm² et 4.10¹⁶ atomes/cm², de préférence au plus 3.10¹⁶ atomes/cm².

Quelques exemples de mise en oeuvre de l'invention sont décrits ci-dessous, dans le cas du silicium.

### Exemple 1

Un substrat monocristallin de silicium d'orientation cristalline (100), revêtu d'une couche d'oxyde thermique SiO₂ d'épaisseur 100nm est implanté dans les conditions suivantes : Bore (80keV et 10¹⁵ at/cm²) + Hélium (34keV et 1,2.10¹⁶at/cm²) + Hydrogène (27keV et 1,2.10¹⁶ at/cm². Le substrat implanté est ensuite désoxydé puis collé à un substrat Si monocristallin (110) par collage moléculaire de type hydrophobe standard (désoxydation HF puis HF-last (ce qui signifie qu'il y a une application de HF à 1% pendant 30 secondes puis un séchage à l'azote). L'énergie de collage étant alors faible à température ambiante (20 mJ/m²), ce collage doit être ensuite consolidé à 700-800°C pour supporter le transfert ultérieur de film, l'énergie de collage venant alors à de l'ordre de 1,5 à 2J/m². Le traitement thermique de fracture (qui assure en parallèle la consolidation de l'interface de collage) consiste alors par exemple en un recuit long : depuis la température ambiante jusqu'à 800°C, avec une rampe de montée de 0,25 à 5°C/min, avec éventuellement des paliers de 2 à 6h tous les 100°C, puis une redescente en température lente, de 0,25 à 3°C/min. Ce traitement thermique ne provoque pas à lui seul la fracture ; celle-ci est provoquée mécaniquement par l'insertion d'une lame à l'interface de collage. On obtient un film Si (100) d'épaisseur d'environ 225 nm (∼225nm) reporté sur un substrat Si (110), qui peut être utilisé pour la réalisation de composants microélectroniques avancés.

Il est à noter que les conditions d'implantation correspondent, au moins approximativement à l'optimum indiqué ci-dessus.

On appréciera que, malgré l'importance de la durée du traitement à haute température (plusieurs heures au-dessus de 600°C), le moment de la fracture de détachement a été bien contrôlé, au moment de l'insertion d'une lame. Par contre, en l'absence de la triple implantation prévue par l'invention, il est certain qu'on aurait constaté une fracture thermique intempestive dès les basses températures du traitement thermique, en dessous de 500°C, sans qu'une consolidation de l'interface de collage puisse intervenir (il en découle un film mince défectueux (NB : il peut être intéressant d'assurer, par un même traitement thermique à 800°C, à la fois la consolidation de l'interface de collage et la fracture).

### Exemple 2

Un substrat Si est implanté dans les conditions suivantes : Bore (150keV et 5.10¹⁴ at/cm² + Hélium (65keV et 10¹⁶/cm² + Hydrogène (60keV et 2.10¹⁶ at/cm². On fait alors croître sur le substrat implanté une couche épaisse (∼10à 50µm) de Si monocristallin, par épitaxie en phase liquide (LPE) à 700°C. On réalise alors une technologie consistant à réaliser des cellules solaires de type HIT (acronyme correspondant à l'expression anglaise pour « hétérojonction avec couche mince intrinsèque »). La surface épitaxiée et ainsi processée est ensuite collée sur un film mince métallique (feuille d'aluminium ou d'acier) au moyen d'une pâte métallique ou d'un polymère conducteur, et la fracture est provoquée mécaniquement au niveau de la zone implantée, par l'application de forces mécaniques (pelage, ultra-sons, traction, cisaillement,...). On obtient ainsi une cellule photovoltaïque en Si monocristallin d'épaisseur ∼10 à 50µm.

On peut noter que les conditions d'implantation correspondent, par rapport à celles de l'exemple 1, à une implantation de bore à une plus grande énergie mais avec une dose deux fois moindre, à une implantation d'hélium à la même dose mais avec une énergie de près du double, et à une implantation d'hydrogène avec une dose et une énergie proches du double. Toutefois, les profondeurs d'implantation sont sensiblement les mêmes pour l'hélium et pour le bore (de l'ordre de 500 nm), inférieure à la profondeur d'implantation d' l'hydrogène d'une distance qui peut être évaluée à environ 70 nm.

On appréciera que, malgré l'existence de traitements à haute température, pour l'épitaxie et pour la formation de composants utiles, le moment de la fracture de détachement a été bien contrôlé, au moment de l'insertion d'une lame. Par contre, en l'absence de la triple implantation prévue par l'invention, il est certain qu'on aurait constaté un cloquage ou une exfoliation des substrats (or le cloquage altère la qualité du film épitaxié, tandis que l'exfoliation entraîne une perte de la zone implantée donc une baisse de la fragilisation et rend donc plus aléatoire le contrôle de la fracture.

### Exemple 3

Un substrat Si est implanté dans les conditions suivantes : Bore (80keV et 10¹⁴ at/cm² + Hélium (34keV et 1,2.10¹⁶at/cm²) + Hydrogène (27keV 1,2.10¹⁶ at/cm²). Le substrat implanté subit ensuite une ou plusieurs étapes technologiques impliquant un recuit à 500°C pendant une durée totale de 1 h30. Ces étapes technologiques peuvent consister par exemple en un dépôt d'une couche de collage épaisse (SiO₂, Si₃N₄, Si polycristallin) suivi par exemple d'un recuit de densification à 500°C. Le substrat implanté et processé est ensuite collé sur un substrat support, par adhésion moléculaire. La fracture est ensuite provoquée thermiquement, par un recuit isotherme à 600°C pendant 10min.

Il est à noter que, par rapport aux conditions optimales identifiées ci-dessus, la dose de bore est 10 fois moindre. Toutefois, malgré les divers traitements thermiques subis, le moment de la fracture de détachement est bien maîtrisé, ici de manière uniquement thermique à au moins 600°C. Pourtant, en l'absence d'une telle implantation triple, il est certain que l'on aurait constaté, comme cela a été expliqué à propos de l'exemple 2, un cloquage ou une exfoliation.

## Revendications

1. Procédé de détachement par fracture d'un film mince (15) à partir d'un substrat de départ (10), comportant
- une étape d'implantation d'espèces au sein du substrat de départ, au travers d'une face libre, en vue de la formation d'une couche de fragilisation (13), le substrat de départ étant, au moins dans sa partie située sous la face libre, sur une profondeur au moins égale à l'épaisseur du film mince à détacher, constitué de silicium,
- au moins une étape intermédiaire impliquant un traitement thermique à une température d'au moins 450°C,
- une étape de détachement par fracture le long de la couche de fragilisation,
**caractérisé en ce que** l'étape d'implantation comporte une implantation de bore, une implantation d'hélium et une implantation d'hydrogène, dans un ordre quelconque, avec des énergies d'implantation telles que :
- on obtient des maxima de concentration en hélium et en bore sensiblement à une même profondeur, avec un écart d'au plus 10 nm,
- on obtient un maximum de concentration en hydrogène à une profondeur supérieure d'au moins 20 nm à celle des maxima de concentration en hélium et en bore,
et avec des doses d'implantation telles que :
• la dose de bore est au moins égale à 5.10¹³ B/cm²
• la dose totale d'hélium et d'hydrogène est au moins égale à 10¹⁶ atomes/cm² et au plus égale à 4.10¹⁶ atomes/cm².

2. Procédé selon la revendication 1, **caractérisé en ce qu'**il comporte en outre une étape de solidarisation pour mettre la face libre en contact intime avec un raidisseur (12).

3. Procédé selon la revendication 1 ou la revendication 2, **caractérisé en ce que** la dose d'implantation de bore est au moins égale à 1% de la dose totale d'hélium et d'hydrogène et au plus égale à 10% de cette dose totale.

4. Procédé selon l'une quelconque des revendications 1 à 3, **caractérisé en ce que** chacune des doses d'hélium et d'hydrogène est au moins égale à 10¹⁵ atome/cm².

5. Procédé selon la revendication 4, **caractérisé en ce que** les doses d'hélium et d'hydrogène sont dans un rapport compris entre ½ et 2.

6. Procédé selon l'une quelconque des revendications 1 à 5, **caractérisé en ce que** la distance entre les maxima de concentration en hélium et en bore, d'une part, et le maximum de concentration en hydrogène, d'autre part, est au plus égale à 200 nm.

7. Procédé selon l'une quelconque des revendications 1 à 6, **caractérisé en ce que** la fracture est obtenue par un traitement thermique de fracture qui est au moins en partie réalisé à une température au moins égale à 450°C.

8. Procédé selon l'une quelconque des revendications 1 à 7, **caractérisé en ce que** la fracture est obtenue par un traitement thermique de fracture qui est au moins en partie réalisé à une température au moins égale à 600°C.

9. Procédé selon l'une quelconque des revendications 1 à 8, **caractérisé en ce que** la fracture est provoquée par application d'une énergie sous forme mécanique.

10. Procédé selon l'une quelconque des revendications 1 à 9, **caractérisé en ce que** la dose totale d'hélium et d'hydrogène est au plus égale à 3.10¹⁶ atomes/cm².

## Patentansprüche

1. Verfahren zur Ablösung durch Trennung eines Dünnschichtfilms (15) von einem Donorsubstrat (10), umfassend
- einen Schritt zur Implantation von Spezies in das Donorsubstrat, durch eine freie Oberfläche, um eine Versprödungsschicht (13) zu bilden, wobei das Donorsubstrat mindestens in dem Teil, der unter der freien Oberfläche liegt, auf einer Tiefe, die mindestens gleich der Dicke des abzutrennenden Dünnfilms ist, aus Silizium besteht,
- mindestens einen Zwischenschritt, der eine Wärmebehandlung bei einer Temperatur von mindestens 450 °C beinhaltet,
- einen Schritt zur Ablösung durch Trennung entlang der Versprödungsschicht,
**dadurch gekennzeichnet, dass** der Schritt der Implantation eine Implantation von Bor, eine Implantation von Helium und eine Implantation von Wasserstoff in beliebiger Reihenfolge umfasst, mit derartigen Implantationsenergien, dass:
- maximale Helium- und Borkonzentrationen im Wesentlichen bei einer gleichen Tiefe, mit einem Abstand von höchsten 10 nm, erhalten werden,
- eine maximale Wasserstoffkonzentration mehr als mindestens 20 nm tiefer als die maximalen Helium- und Borkonzentrationen erhalten wird,
und mit derartigen Implantationsdosen, dass:
• die Bordosis mindestens gleich 5.10¹³B/cm² beträgt,
• die Gesamtdosis von Helium und Wasserstoff mindestens gleich 10¹⁶ Atome/cm² und höchstens gleich 4.10¹⁶ Atome/cm² beträgt.

2. Verfahren nach Anspruch 1, **dadurch gekennzeichnet, dass** es ferner einen Schritt zum Haftverbinden umfasst, um die freie Oberfläche in engen Kontakt mit einem Versteifer (12) zu bringen.

3. Verfahren nach Anspruch 1 oder Anspruch 2, **dadurch gekennzeichnet, dass** die Borimplantationsdosis mindestens gleich 1 % der Gesamtdosis von Helium und Wasserstoff und höchstens gleich 10 % dieser Gesamtdosis entspricht.

4. Verfahren nach einem der Ansprüche 1 bis 3, **dadurch gekennzeichnet, dass** jede der Helium- und Wasserstoffdosen mindestens gleich 10¹⁵ Atome/cm² beträgt.

5. Verfahren nach Anspruch 4, **dadurch gekennzeichnet, dass** die Helium- und Wasserstoffdosen in einem Verhältnis zwischen 1/2 und 2 liegen.

6. Verfahren nach einem der Ansprüche 1 bis 5, **dadurch gekennzeichnet, dass** der Abstand zwischen den maximalen Helium- und Borkonzentrationen einerseits und der maximalen Wasserstoffkonzentration andererseits höchsten gleich 200 nm beträgt.

7. Verfahren nach einem der Ansprüche 1 bis 6, **dadurch gekennzeichnet, dass** die Trennung durch eine Trennungswärmebehandlung erhalten wird, die mindestens teilweise bei einer Temperatur von mindestens gleich 450 °C ausgeführt wird.

8. Verfahren nach einem der Ansprüche 1 bis 7, **dadurch gekennzeichnet, dass** die Trennung durch eine Trennungswärmebehandlung erhalten wird, die mindestens teilweise bei einer Temperatur von mindestens gleich 600 °C ausgeführt wird.

9. Verfahren nach einem der Ansprüche 1 bis 8, **dadurch gekennzeichnet, dass** die Trennung durch die Anwendung einer mechanischen Energieform herbeigeführt wird.

10. Verfahren nach einem der Ansprüche 1 bis 9, **dadurch gekennzeichnet, dass** die Gesamtdosis von Helium und Wasserstoff höchstens gleich 3.10¹⁶ Atome/cm² beträgt.

## Claims

1. A process for detaching a thin film (15) from a donor substrate (10) by cleaving, comprising:
- a step of implanting species within the donor substrate, through a free surface, with a view to forming a weak layer (13), the donor substrate being, at least in its part located below the free surface, over a depth at least equal to the thickness of the thin film, made of silicon, to be detached;
- at least one intermediate step involving a heat treatment at a temperature of at least 450°C; and
- a step of detachment by cleaving along the weak layer,
**characterized in that** the implantation step comprises implanting boron, helium and hydrogen in any order with implantation energies such that:
- helium and boron concentration maxima are obtained at substantially the same depth, separated by at most 10 nm; and
- a hydrogen concentration maximum is obtained at a depth at least 20 nm greater than that of the helium and boron concentration maxima,
and with implantation doses such that:
• the boron dose is at least equal to 5×10¹³ B/cm²; and
• the total dose of helium and hydrogen is at least equal to 10¹⁶ atoms/cm² and at most equal to 4×10¹⁶ atoms/cm².

2. Process according to Claim 1, **characterized in that** it furthermore comprises a bonding step to bring the free side into intimate contact with a carrier (12).

3. Process according to either of Claims 1 and 2, **characterized in that** the boron implantation dose is at least equal to 1% of the total dose of helium and hydrogen and at most equal to 10% of this total dose.

4. Process according to any one of Claims 1 to 3, **characterized in that** each of the helium and hydrogen doses is at least equal to 10¹⁵ atoms/cm².

5. Process according to Claim 4, **characterized in that** the helium and hydrogen doses are in a ratio of between ½ and 2.

6. Process according to any one of Claims 1 to 5, **characterized in that** the distance between the helium and boron concentration maxima, on the one hand, and the hydrogen concentration maximum, on the other hand, is at most equal to 200 nm.

7. Process according to any one of Claims 1 to 6, **characterized in that** the cleave is obtained via a cleaving heat treatment that is at least partially carried out at a temperature at least equal to 450°C.

8. Process according to any one of Claims 1 to 7, **characterized in that** the cleave is obtained via a cleaving heat treatment that is at least partially carried out at a temperature at least equal to 600°C.

9. Process according to any one of Claims 1 to 8, **characterized in that** the cleaving is induced via application of mechanical energy.

10. Process according to any one of Claims 1 to 9, **characterized in that** the total dose of helium and hydrogen is at most equal to 3×10¹⁶ atoms/cm².
